(19) Europäisches Patentamt / European Patent Office / Office européen des brevets

(11) **EP 3 109 910 B1**

## (12) EUROPEAN PATENT SPECIFICATION

(45) Date of publication and mention
of the grant of the patent:
**21.03.2018   Bulletin 2018/12**

(51) Int Cl.:
***H01L 35/32*** *(2006.01)*

(21) Application number: **15174166.7**

(22) Date of filing: **26.06.2015**

(54) **THERMOELECTRIC DEVICE**

THERMOELEKTRISCHE VORRICHTUNG

DISPOSITIF THERMOÉLECTRIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**28.12.2016   Bulletin 2016/52**

(73) Proprietor: **European Thermodynamics Limited
Kibworth, Leicester LE8 0RX (GB)**

(72) Inventors:
• **Tuley, Richard
Leicester, Leicestershire LE8 0RX (GB)**

• **Simpson, Kevin
Leicester, Leicestershire LE8 0RX (GB)**

(74) Representative: **Barker Brettell LLP
100 Hagley Road
Edgbaston
Birmingham B16 8QQ (GB)**

(56) References cited:
**EP-A1- 2 128 907        WO-A2-2006/001827
JP-A- 2006 086 510       US-A- 4 947 648
US-A1- 2008 017 238      US-A1- 2009 084 421**

Printed by Jouve, 75001 PARIS (FR)

## Description

The present invention relates to thermoelectric devices, in particular thermoelectric devices for energy generation. In particular, the invention relates to a thermoelectric generator and a method of making such a thermoelectric generator.

Many electrical systems, such as sensors, may be in positions where it is not convenient or economically viable to power them by means of hard wiring them to a central power source such as the electrical grid. For example, if the electrical system is in a remote or inaccessible location or is required to be mobile, mains power is not available. Typically, such electrical systems may be powered by batteries. However, batteries are limited by the total stored charge, and therefore access to the electrical system is needed to replace the batteries. Such access can be challenging, unsafe and/or expensive, therefore making the systems difficult to maintain.

Moreover, the need to frequently replace batteries can be expensive and is not environmentally friendly. The need to have sufficient replacement batteries available can also be detrimental if space and/or weight is at a premium.

One solution to these problems is to have an energy generation device associated with the electrical system, so that it can be electrically self-sufficient (e.g. a so-called "fit- and-forget" system) and/or to increase the lifetime of a battery. For example, the energy generation device may re-charge one or more batteries.

A thermoelectric generator is an example of such an energy generating device, and can be used wherever there is a temperature difference. For example, a thermoelectric generator can operate using the temperature difference between a hot pipe or surface and the ambient air temperature.

Generally, the temperature differences available are often small, and so a standard thermoelectric generator module may produce sufficient power, but at a very low voltage. The low voltages can be difficult to interface efficiently with the required electrical system. There is therefore a need to create thermoelectric generators capable of producing sufficiently high voltages even at low temperature differences.

To achieve a high voltage at low temperature differences, a large number of thermoelectric elements (e.g. semiconductors) need to be connected electrically in series. Standard thermoelectric modules have a lower limit on the cross sectional area of the thermoelectric elements perpendicular to the temperature gradient due to the requirements of mechanical stability, and minimum size for sufficient yield in cutting and assembly. Therefore, in a standard thermoelectric generator module a large number of thermoelectric elements may result in a large and costly device.

An alternative method to produce a large number of thermoelectric elements is to have the thermoelectric elements disposed on a substrate, with a temperature gradient parallel to the substrate. This allows the use of a much smaller cross section of a thermoelectric element perpendicular to the temperature gradient; as for example the substrate support may provide mechanical support, ease of handling and easier thermoelectric element formation. In order to then achieve the required number of thermoelectric elements, the substrates can be stacked or layered in a compact or low cost manner.

For example, CA2549826C discloses a thermoelectric energy generator for high voltage operation, comprising a sputter coated thermoelectric material with a length to area ratio between 500 cm$^{-1}$ and 10000 cm$^{-1}$ on a flexible substrate, which may be wound around a spindle.

US3758346 also discloses a thermoelectric generator where the thermoelectric material is applied onto a carrier film which is then rolled into a hollow cylinder.

In another example, Journal of Applied Physics: Conference series 557 (2014) 012016 discloses a printed thermoelectric material on a flexible substrate, which is then rolled into a hollow cylinder.

US2008/0017238A1 discloses a thermoelectric device including a plurality of n-type thermoelectric elements and a plurality of p-type thermoelectric elements connected in series. Each thermoelectric element comprises a hollow cylindrical support structure with an external surface covered by multiple layers of a thermoelectric material and a flexible substrate.

According to a first aspect of the invention, there is provided a thermoelectric device, e.g. a thermoelectric generator, as defined in claim 1.

Advantageously, by selecting a spindle having a thermal resistance between the first end and the second end of more than 0.1 KW$^{-1}$, a sufficient temperature difference may be maintained, in use, across the thermoelectric elements, e.g. to generate a relatively high voltage output even at relatively small temperature differences. Additionally or alternatively, the inclusion of a spindle may help to provide a thermoelectric device that is mechanically robust. Accordingly, the thermoelectric device may be suitable for use in relatively harsh conditions and/or in relatively inaccessible locations. For instance, the thermoelectric device may be used to power pipeline monitoring sensors.

The invention also provides an improved spindle that provides mechanical support to a thermoelectric generator, whilst maintaining a sufficient temperature difference across the thermoelectric elements to generate a higher voltage output even at small temperature differences.

The hot side of the thermoelectric device may be configured to be connected to a high temperature source and the cold side of the thermoelectric device may be configured to be connected to a low temperature source.

In an embodiment, the spindle may comprise sections in series with each other, the sections having different thermal resistances, in which case the thermal resistance between the first end and the second end would be the sum of each of these thermal resistances from the first end to the second end.

In some embodiments, the thermal resistance of the spindle between the first end and the second end may be more than 0.5 KW$^{-1}$, more than 1 KW$^{-1}$, more than 5 KW$^{-1}$, more than 10 KW$^{-1}$, or more than 50 KW$^{-1}$.

In an embodiment, the distance between the first end and the second end of the spindle may be substantially equal to the distance between the hot side and the cold side of the thermoelectric device.

In an embodiment, the substrate may be provided by the spindle, i.e. the thermoelectric element(s) may be disposed directly on the spindle.

Typically, the substrate may comprise a discrete component, typically having the form of a thin film or sheet. The substrate may comprise, or consist essentially of, a polymeric material, e.g. a polyimide such as Kapton®.

Optionally, the substrate may be designed to fit at least partially around the spindle between the hot side and the cold side. For example, the substrate may be a sleeve sized to fit around the spindle, or a band configured to be secured at least partially around the spindle. In some embodiments the substrate may be rigid, or foldable.

Optionally, the substrate may be a flexible substrate such that, in use, the flexible substrate can be wrapped at least partially around the spindle. In some embodiments, the substrate may comprise one or more locking means designed to secure the substrate around the spindle.

In some embodiments, the flexible substrate may have a length that is larger than the circumference of the spindle, such that the flexible substrate can wrap more than once around the spindle, creating layers of the substrate.

Alternatively, the thermoelectric device may comprise a plurality of substrates with at least one thermoelectric element disposed thereon, the substrates overlapping at least partially to provide a layered arrangement of substrates.

The thermoelectric elements may comprise p-type and/or n-type semiconductor materials.

Preferably, the thermoelectric element(s) may extend along a portion of the length of the spindle. The thermoelectric element(s) may extend substantially parallel to a line between the hot side and the cold side on the surface of the spindle.

Optionally, a plurality of thermoelectric elements may be disposed on the substrate, wherein the plurality of thermoelectric elements is electrically connected in series. For instance, an electrically conductive element may connect each pair of neighbouring thermoelectric elements. The plurality of thermoelectric elements may be disposed on the substrate such that the thermoelectric elements alternate between p-type and n-type semiconductor materials.

In other embodiments, the thermoelectric elements may be directly electrically connected in series on the substrate (i.e. without the need for any conductive elements).

In an embodiment, the spindle may be substantially straight.

The spindle may have any cross-sectional shape. For instance, the spindle may be polygonal, curvilinear, elliptical or round in cross-section.

Optionally, the shape of the spindle may not be uniform between the hot side and the cold side. For example, the curvature of a round cross-section or at least partially rounded cross-section spindle may be smaller at positions where, in use, a thermoelectric element is disposed proximate the spindle.

The spindle may be engineered or configured such that the thermal resistance varies continuously or in a step-wise manner within at least a portion of the spindle, typically in accordance with a predetermined design. The material composition and/or the shape and dimensions of the spindle may be selected in order to provide a spindle having the desired thermal resistance between the first end and the second end.

In some embodiments, the spindle may comprise more than one material, each material having a different thermal conductivity. The spindle may comprise a composite material formed by combining two or more different materials. Optionally, the composite material may be engineered such that the thermal conductivity of the spindle is lower at the centre of the spindle than at the ends of the spindle proximate the hot side or cold side of the generator.

Optionally, the spindle may comprise two or more distinct sections comprising different materials. The distinct sections of the spindle may be formed integrally, or separately.

Optionally, the thermal resistance of the end portion(s) may be less than 50 KW$^{-1}$ or less than 10 KW$^{-1}$, or less than 5 KW$^{-1}$, or less than 1 KW$^{-1}$, or less than 0.5 KW$^{-1}$, or less than 0.1 KW$^{-1}$.

When assembled for use, the substrate at least partially overlaps with the end portion(s). The amount of the overlap may be variable, and/or the amount of the overlap may be different at each end portion.

Optionally, the thermoelectric generator may comprise at least one conductive member coupled to the first end or the second end of the spindle. For example, the conductive member(s) may have a thermal conductivity of more than 10 WW$^{-1}$K$^{-1}$. The generator may further comprise at least one thermally conductive connector configured to connect at least a portion of the substrate proximate the hot side or cold side to the first conductive portion(s).

Optionally, the thermoelectric generator may comprise two conductive members, one conductive member being coupled to the first end of the spindle and the other conductive member being coupled to the second end of the spindle.

Optionally, the thermally conductive connector(s) may comprise a wire, or a thermal adhesive, grease, epoxy, film, foam, and/or graphite sheet. In some embodiments, the first and/or second conductive portions may be removably connectable to the spindle.

In some embodiments, the spindle may comprise nylon. Optionally, the spindle may, at least partially, comprise other polymeric materials, and/or metals, such as steel or stainless steel.

The thermoelectric element(s) may be disposed on the substrate by any suitable technique, e.g. by using an adhesive and/or mechanical fastening means, soldering, electroplating, chemical vapour deposition, physical vapour deposition, sputtering, spray deposition, or printing.

Optionally, the at least one thermoelectric element may be printed onto the substrate.

In some embodiments, in use the thermoelectric element(s) may be disposed, on average, further from the spindle than the substrate. For example, the thermoelectric element(s) may be printed on the surface of the substrate that does not come into contact with the spindle (i.e. the upper surface of the substrate).

In other embodiments, in use the thermoelectric element(s) may be disposed, on average, closer to the spindle than the substrate. For example, the thermoelectric element(s) may be printed on the surface of the substrate that comes into contact with the spindle (i.e. the lower surface of the substrate). Optionally, the thermoelectric element(s) may be disposed, e.g. printed, on both the upper and lower surfaces of the substrate.

Optionally, the thermoelectric generator may be at least partially encapsulated in an outer enclosure. In some embodiments, the entire thermoelectric generator may be surrounded by the enclosure. The high temperature source and or low temperature source may be encapsulated in the enclosure.

Optionally, the enclosure may prevent external air (or other gasses) and/or fluids from entering the enclosure. For example, the enclosure may be air-tight and/or water-tight.

According to a second aspect of the present invention, there is provided a wireless sensor system, or a pipeline monitoring system, comprising one or more sensors and one or more thermoelectric devices according to the first aspect of the invention. In an embodiment, the thermoelectric device(s) may comprise one or more thermoelectric generators coupled to at least one sensor, and/or to at least one battery, in order to provide power to the one or more sensors.

According to a third aspect of the present invention, there is provided a method of use of the thermoelectric generator of any embodiment of the first aspect of the invention to generate electricity, the method comprising:

connecting the hot side of the thermoelectric generator to a high temperature source; and
connecting the cold side of the thermoelectric generator to a low temperature source, thereby setting up a temperature difference across the thermoelectric element(s).

According to an aspect there is provided a spindle for use in a thermoelectric device, the spindle having a first end and a second end, wherein the thermal resistance of the spindle between the first end and the second end is more than 0.1 $KW^{-1}$. Advantageously, the spindle may be easily retrofitted into existing thermoelectric generators (or devices) in order to improve the output voltage of the generators.

According to a fourth aspect of the present invention, there is provided a method of manufacturing or assembling a thermoelectric device according to claim 14.

The method may comprise the steps of disposing the thermoelectric element(s) onto a substrate. This may include printing the thermoelectric element(s) onto the substrate, wherein the substrate may be a flexible and/or thin film substrate.

Optionally, the method may include manufacturing the spindle. For example, the method may include fabricating a composite spindle (either from a single composite material or multiple distinct sections of different materials, which may or may not be composite materials). This may be done using a composite moulding and/or curing process.

Optionally, the method may comprise connecting two or more sections of the spindle together, such as a conductive end portion and a middle portion of the spindle. The portions may be mechanically connected, for example by screws and/or fasteners etc.. In some embodiments, the portions of the spindle may be attached via an adhesive (e.g. a glue).

The method may comprise disposing the substrate around the spindle, such that the thermoelectric elements are disposed between the hot side and the cold side of the spindle. This may include using one or more locking means on the substrate to secure the substrate around the spindle.

A spindle for use in this invention may be manufactured by any suitable manufacturing process. The manufacturing process may comprise a subtractive or an additive manufacturing process, e.g. a three-dimensional printing process.

Another aspect provides a computer-readable medium having computer-readable instructions adapted to cause a printer to print a spindle for use in a thermoelectric device, the spindle having a first end and a second end, wherein the thermal resistance of the spindle between the first end and the second end is more than 0.1 $KW^{-1}$.

Embodiments of the invention will now be described, by way of example only, with reference to the accompanying drawings, in which:

Figure 1A is a schematic illustration of thermoelectric elements disposed on a flexible substrate;

Figure 1B is a schematic illustration of a thermoelectric generator comprising the flexible substrate and thermoelectric elements illustrated in Figure 1A rolled around a spindle;

Figure 2 is an example of the change in temperature between the ends of a thermoelectric element as the thermal conductivity of the spindle changes;

Figure 3 is a schematic illustration of an embodiment of a spindle for use in a thermoelectric generator;

Figure 4 is an example of the change in temperature between the ends of a thermoelectric element as the overlap between the substrate and a more thermally conductive end section is varied;

Figure 5 is a schematic illustration of the front view of a thermoelectric generator in accordance with an embodiment of this invention; and

Figure 6 is a schematic illustration of the front view of a thermoelectric generator in accordance with an embodiment of this invention.

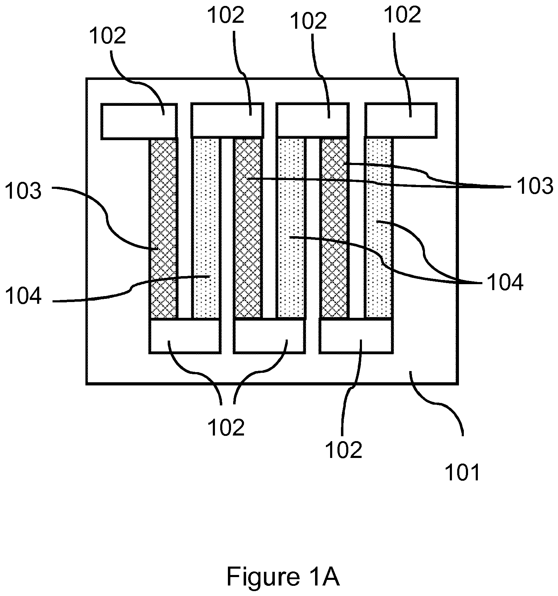

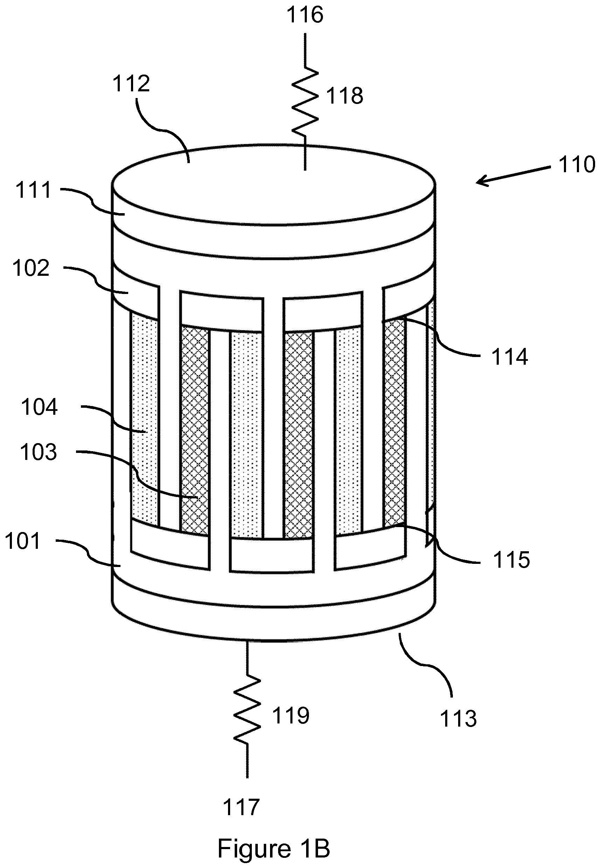

A schematic illustration of a thermoelectric generator 110 in accordance with an embodiment is shown in Figure 1. P-type thermoelectric elements 103 and n-type thermoelectric elements 104 are disposed on a flexible substrate 101 as shown in Figure 1A.

The p-type 103 and n-type 104 thermoelectric elements may be joined electrically in series by conductive elements 102 which are disposed on the substrate 101. The conductive elements 102 may overlap the ends of the thermoelectric elements 103, 104. Where the conductive elements 102 overlap the thermoelectric elements 103, 104, the conductive elements 102 may be disposed between the thermoelectric elements 103, 104 and the substrate 101, or the thermoelectric elements 103, 104 may be disposed between the conductive elements 102 and the substrate 101.

The flexible substrate 101 is rolled or wrapped around a spindle 111 to form the thermoelectric generator 110. The flexible substrate 101 may be rolled or wrapped more than once around the spindle 111, forming multiple layers.

Optionally, the flexible substrate 101 may comprise polymeric film, such as a polyimide film. An example of a suitable polyimide film is Kapton®, manufactured by DuPont.

The flexible substrate 101 may be wound around the spindle 111 such that the thermoelectric material 103, 104 disposed on the substrate 101 lies further from the spindle 111 than the substrate 101. This may be advantageous if the thermoelectric material 103, 104 is strong in tension or to allow easy access to make external electrical connections.

Optionally, the flexible substrate 101 may be wound around the spindle 111 such that the thermoelectric material 103, 104 disposed on the substrate 101 lies closer to the spindle 111 than the substrate 101. This may be advantageous if the thermoelectric material 103 is strong in compression.

The thermoelectric material 103, 104 may be disposed on the substrate 101 by printing the thermoelectric material 103, 104. A polyimide film may be particularly advantageous for use as a printed circuit board substrate 101.

The thermoelectric material 103, 104 may be heated after printing to improve the performance of the thermoelectric material. In other embodiments, the thermoelectric material 103, 104 may be disposed on the substrate by other thin film deposition techniques, such as (but not exclusively) sputter deposition, or electroplating. In other embodiments the thermoelectric material may physically disposed on the substrate 101, for example by soldering the p-type 103 and n-type 104 semiconductors.

The spindle 111 can provide mechanical support to the flexible substrate, thereby easing assembly. The spindle 111 may also improve the temperature difference across the thermoelectric elements 103.

The spindle 111 does not have to be the shape shown in Figure 1. The spindle 111 may be non-cylindrical. Optionally, the spindle 111 may have a non-uniform cross-section. For example, the thickness of the spindle may taper along its length, or the spindle may have a larger cross-sectional area in the middle portion that at either end.

In some embodiments, the curvature of the spindle 111 around which the flexible substrate 101 is wrapped may be variable. The curvature may be smaller in positions where the thermoelectric elements 103, 104 are disposed on the flexible substrate 101 and larger in a least part of the gaps between the thermoelectric elements 103, 104.

The thermoelectric generator 110 is connected to two external sources of different temperatures, consisting of a hot temperature source 117 and a cold temperature source 116. There is a temperature difference $T_0$ between these temperature sources.

In some embodiments, there may be an additional thermal resistance 119 between the hot side 113 of the thermoelectric generator 110 and the hot temperature source 117. There may be an additional thermal resistance 118 between the cold side 112 of the thermoelectric generator 110 and the cold temperature source 116. The thermal resistances 118 and 119 may consist of one or more thermal interfaces, thermal interface materials, metal spacers, heat exchangers and/or heat sinks.

There is a temperature difference, $T_1$ between the hot side 113 and the cold side 112 of the thermoelectric generator 110. The temperature difference $T_0$ produces a temperature difference $T_2$ between the hot end 115 and cold end 114 of a thermoelectric element 103, 104.

The temperature difference $T_2$ across the thermoelectric element generates a voltage across the thermoelectric element 103, 104, so that electrical power can be delivered to an externally connected electrical load via electrical outputs from the thermoelectric generator (not shown).

The larger the temperature difference $T_2$ the more voltage (hence power) can be output from the thermoelectric generator, as the charge carriers in the thermoelectric elements 103, 104 (electrons or holes) that flow from the hot side to the cold side, thereby setting up an electric current, have more energy. Therefore it is desirable to maximise the value of $T_2$.

Due to the presence of thermal resistances, $T_2 \leq T_1 \leq T_0$ as heat is lost not gained during conductance from the heat source 113 to the thermoelectric element 103. For $T_2$ to be maximised, the thermal resistance between the ends of the thermoelectric elements 103 and the corresponding temperature sources should be minimised. This requires a minimisation of the thermal resistance of the ends of the spindle 111 proximate the hot side and the cold side.

The thermal resistance ($R_T$) of an object is given by the equation:

$$R_T = L \, / \, (\kappa.A) \qquad\qquad - (1)$$

Where L is the length of the object, A is the cross-sectional area of the object and $\kappa$ is the thermal conductivity of the object. The thermal conductivity of an object $\kappa$ is a fixed property (i.e. a constant) of the material from which the object is made. Hence, the thermal resistance of the spindle 111 depends on the material of the spindle 111 and the size and shape of the spindle 111.

The size of the spindle 111 may be fixed by the minimum bend radius that the thermoelectric material (i.e. semiconductor material of the thermoelectric elements) can tolerate before its performance drops. Optionally, the size of the spindle 111 may be fixed by the minimum size for the spindle 111 to provide adequate mechanical support to the substrate 101 and/or to ensure ease of assembly. Therefore, the spindle 111 comprises at least partially of a solid material.

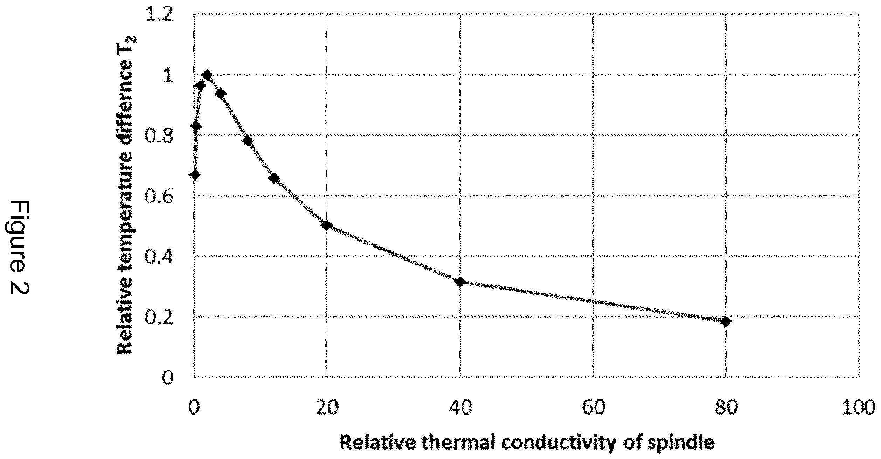

As shown, the thermal resistance of the spindle 111 may be determined by the choice of material. Figure 2 illustrates a computer modelled example of the impact of the change in the relative value of the thermal conductivity of the spindle material on the relative value of the temperature difference $T_2$ when the temperature difference between the sources $T_0$ is held constant. It can be seen that a high thermal conductivity spindle must be avoided.

In some embodiments, the spindle 111 may have a uniform thermal conductivity between the hot side 113 and the cold side 112. In other embodiments, the spindle 111 may have a non-uniform thermal conductivity between the hot side 113 and the cold side 112.

Optionally, the spindle 111 may comprise two or more different materials, each material having a different thermal conductivity. In one embodiment of the invention the spindle is at least partially made from nylon.

In some embodiments, the spindle 111 may comprise two or more distinct sections, each section comprised of a different material, wherein the sections are joined to form a single spindle 111. For example, the sections may be joined by an adhesive (e.g. a glue), or mechanically joined, or by a composite curing or moulding process.

In some embodiments, the spindle 111 may comprise one or more composite materials, wherein the thermal conductivity of the composite material is non-uniform across the length of the spindle 111 (i.e. from the hot side 113 to the cold side 112).

If the spindle 111 has a non-uniform thermal conductivity between the hot side 113 and the cold side 112, an effective thermal conductivity of the spindle 111 may be determined. The effective thermal conductivity of the spindle 111 is hereby defined as the uniform thermal conductivity that would result in the same thermal resistance between the hot side 113 and the cold side 112 as the non-uniform spindle.

The value of the effective thermal conductivity is relatively easy to determine, as thermal resistances in series add up. Thus, the thermal resistance between the hot side 113 and the cold side 112 is the sum of the thermal resistances along the spindle 111, which can be calculated using equation 1.

For example, if the spindle comprises two distinct sections, one section having a thermal resistance X and the other section having a thermal resistance Y, and each section having a cross-sectional area A, then the effective thermal conductivity ($\kappa_{EFF}$) of the spindle is equal to:

$$\kappa_{EFF} = L \, / \, ((X + Y) \, . \, A)$$

where L is the length of the spindle between the hot side 113 and the cold side 112.

The effective thermal conductivity of the spindle 111 may be less than 10 $WW^{-1}K^{-1}$. In some embodiments, the effective thermal conductivity of the spindle 111 may be less than 5 $Wm^{-1}K^{-1}$ or less than 1 $Wm^{-1}K^{-1}$.

For example, the spindle 111 may be a hollow steel cylinder comprising a steel outer cylinder and an air filled inner cylinder. The thermal conductivity of air is around 0.02 $Wm^{-1}K^{-1}$ and the thermal conductivity of stainless steel is around 17 $Wm^{-1}K^{-1}$. This spindle has a higher thermal resistance between the hot side 113 and the cold side 112 than a spindle of the same shape that has a uniform thermal conductivity of 10 $WW^{-1}K^{-1}$. Thus, the effective thermal conductivity of the spindle may be less than 10 $WW^{-1}K^{-1}$.

There may be an advantage in defining the thermal properties of the spindle 111 in terms of the effective thermal conductivity, as this property is unaffected by the size or shape of the spindle 111. However, the thermal properties of the spindle 111 can also be defined in terms of the thermal resistance of the spindle 111.

In some embodiments, the thermal resistance of the spindle 111 between the hot side 113 and cold side 112 may be greater than 0.1 $KW^{-1}$, or greater than 0.5 $KW^{-1}$, or greater than 1 $KW^{-1}$, or greater than 5 $KW^{-1}$, or greater than 10 $KW^{-1}$, or greater than 50 $KW^{-1}$.

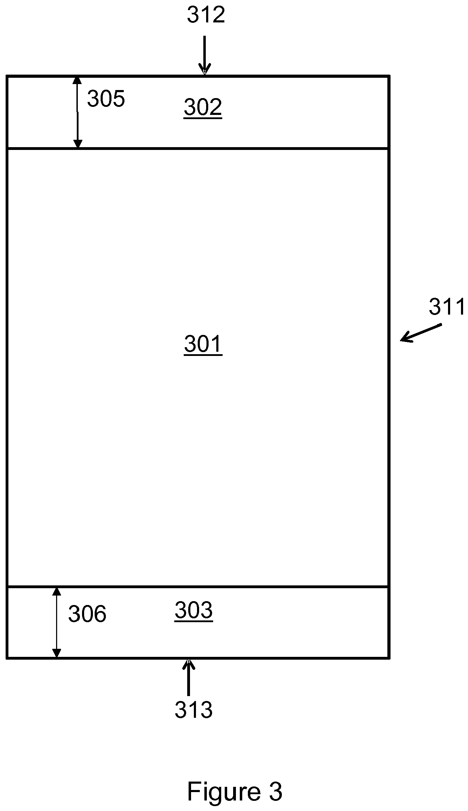

Figure 2 also shows that at very low thermal conductivities of the spindle 111, the temperature difference $T_2$ can actually decrease. This is because the higher thermal resistance of the spindle results in a significant temperature drop between the ends 114, 115 of the thermoelectric element 103 and the hot 113 or cold 112 side of the thermoelectric generator 101. In some embodiments, the spindle 111 may be made of a different material at one or both ends, as shown in Figure 3 which depicts a cross-section of a spindle 311.

For simplicity the thermoelectric elements are not shown in figure 3, however the substrate 101 of figure 1 could be used with the spindle 311. The spindle 311 comprises a middle portion 301 and end portions 302, 303, wherein the end portions 302, 303 have a lower thermal resistance than the middle portion 301.

The middle portion 301 may have an effective thermal conductivity less than 10 $Wm^{-1}K^{-1}$, or a thermal resistance of greater than 0.1 $KW^{-1}$. Optionally, the thermal resistance of the middle portion 301 may be greater than 0.5 $KW^{-1}$, or greater than 1 $KW^{-1}$, or greater than 5 $KW^{-1}$, or greater than 10 $KW^{-1}$, or greater than 50 $KW^{-1}$. At least one of the end portions 302, 303 may have an effective thermal conductivity greater than 10 $Wm^{-1}K^{-1}$, or a thermal resistance of less than 50 $KW^{-1}$, Optionally, the end portions may have a thermal resistance of less than 10 $KW^{-1}$, or less than 5 $KW^{-1}$, or less than 1 $KW^{-1}$, or less than 0.5 $KW^{-1}$, or less than 0.1 $KW^{-1}$.

The higher thermal conductance of at least one end portion 302, 303 of the spindle 311 decreases the temperature drop between the corresponding hot side 313 and the hot end 115 of the thermoelectric elements, or cold side 312 and the cold end 114 of the thermoelectric elements. Advantageously, this may lead to a desirable increase in the electrical output of the thermoelectric generator.

The thermoelectric elements 103, 104 may overlap with the higher thermal conductance end portions 302, 303 of the spindle 311. There exists a balance however in the size of the overlap 305 or 306 between the thermoelectric elements and the end portions.

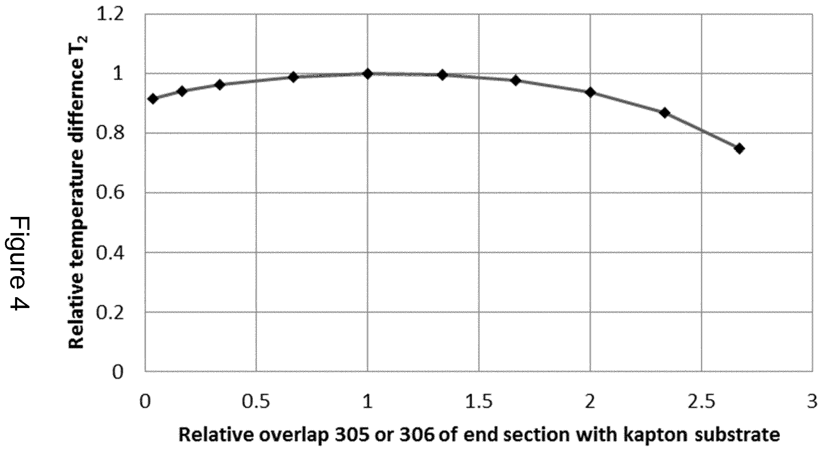

This balance is shown in Figure 4, where it can be seen that introducing an overlap 305 or 306 desirably increases the temperature difference $T_2$, but that too much overlap 305, 306 decreases the temperature difference $T_2$. This is because too much heat is conducting across the thermoelectric elements and spindle as the total thermal resistance of the spindle is decreased, which reduces the temperature difference between the ends of the thermoelectric elements 103, 104.

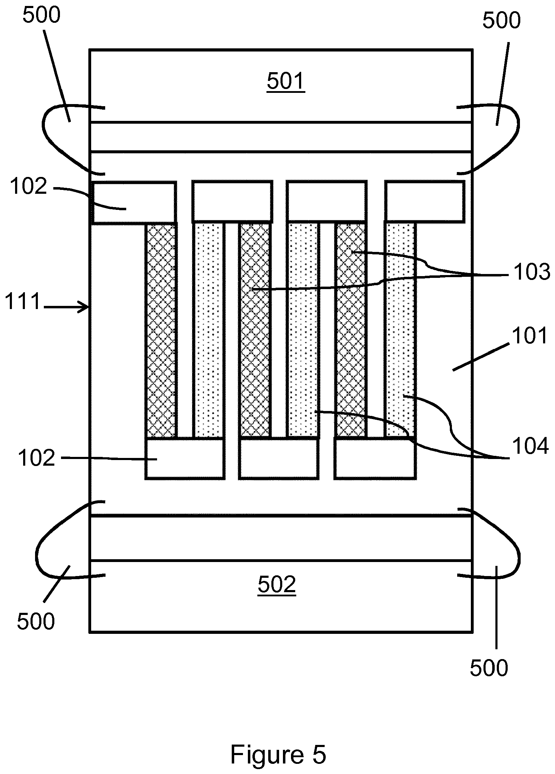

A schematic illustration of the front view of another embodiment of a thermoelectric generator is shown in Figure 5. In this embodiment the difference between $T_2$ and $T_1$ is reduced by using at least one thermally conductive connector 500 to join the ends of the substrate 101 to a conductive member 501 or 502 (i.e. thermally conductive) coupled to the hot side or cold side of the generator. The thermally conductive members 501, 502 may be formed separately to the spindle 111.

In some embodiments the thermally conductive members 501, 502 have a thermal conductivity of more than 10 $WW^{-1}K^{-1}$. In some embodiments, the thermal conductivity of the conductive members may be more than 20 $WW^{-1}K^{-1}$. Optionally, multiple thermally conductive connectors 500 may be provided to connect the substrate to a conductive member 501, 502. In some embodiments, only one conductive member 501, 502 may be provided.

In some embodiments, the thermally conductive connector 500 may be a conductive wire. Optionally, the thermally conductive connecter 500 may at least initially be non-rigid, for example a thermal grease, adhesive, epoxy, film, foam, graphite sheet or phase change material. The thermally conductive connector 500 may contact at least one of the substrate 501 and the thermoelectric elements 503, 504.

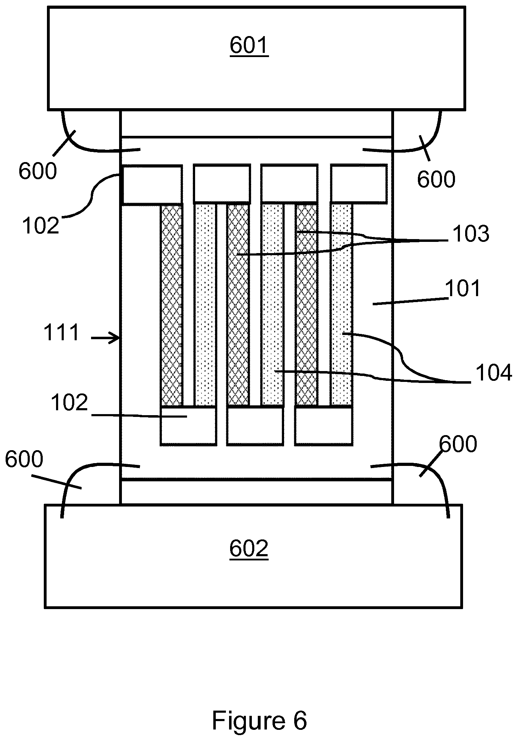

An alternative example of this embodiment is shown in Figure 6, wherein a thermally conductive connector 600 joins the ends of the substrate 601 to a thermally conductive member 601 or 602 of the generator.

In some embodiments, the thermoelectric generator according to any aspect of the present invention may be held onto a hot source by straps, wire, rope or other connecting means under tension that originates from a position at least as far from the hot source as the cold side of the thermoelectric generator. The straps, wire or rope hold the thermoelectric generator in compression, increasing the compressive pressure on any thermal interfaces, which may reduce any interfacial thermal resistance.

Optionally, the thermoelectric generator may be encapsulated by an outer enclosure. This enclosure may be made of nylon, or other polymeric materials, or metal, or a combination of different materials. The enclosure may be water tight and/or air tight. The enclosure may improve the lifetime of the thermoelectric generator, for example by preventing water damage, build-up of dust, algae or other foreign particles, or damage caused by other environmental (such as storms or wildlife).

The thermoelectric generator of the present invention may be associated with an electrical system in a remote or inaccessible location. In particular, the thermoelectric generator may be associated with sensor systems and/or wireless sensor systems. For example, this may include industrial sensors, building sensors, pipeline monitoring systems (e.g. subterranean pipeline monitoring systems), or weather sensors.

The thermoelectric generator of the present invention may provide a higher-voltage output than known thermoelectric devices. As such, the thermoelectric generator may be more efficient at recharging one or batteries in an electrical system, and/or providing more efficient back-up power and/or self-sufficient power to the system.

The above embodiments are described by way of example only. Many variations are possible without departing from the invention.

**Claims**

1. A thermoelectric device, e.g. a thermoelectric generator, (101) having, in use, a hot side (113, 313) and a cold side (112, 312), the thermoelectric device comprising: a spindle (111, 311) having a first end and a second end, the spindle being arranged such that, in use, the first end is proximate the hot side and the second end is proximate the cold side of the thermoelectric device; and at least one thermoelectric element (103, 104) disposed on a substrate (101) between the first end and the second end of the spindle; the spindle further comprising, in series, a middle portion (301) and at least one end portion (302, 303), at the first end and/or the second end of the spindle, the end portion(s) having a lower thermal resistance than the middle portion of the spindle; wherein the effective thermal resistance of the spindle between the first end and the second end is more than 0.1 $KW^{-1}$; and wherein the or each thermoelectric element overlaps (305, 306) with the end portion(s) of the spindle.

2. The thermoelectric device of claim 1, wherein the effective thermal conductivity of the spindle between the hot side and the cold side is less than $10\,Wm^{-1}K^{-1}$, less than $5\,Wm^{-1}K^{-1}$, or less than $1\,WW^{-1}K^{-1}$.

3. The thermoelectric device of claim 1 or claim 2, wherein the effective thermal conductivity of the end portion(s) is greater than $10\,Wm^{-1}K^{-1}$.

4. The thermoelectric device of claim 1, claim 2 or claim 3, wherein the spindle comprises a different material at one or both end portions, such that the thermal conductivity of the end portion(s) is higher than that of the middle portion.

5. The thermoelectric device of any of claims 1 to 4, wherein the spindle comprises an end portion at both the first end and the second end of the spindle, and a middle portion between the end portions.

6. The thermoelectric device of any preceding claim, wherein the substrate is a flexible substrate such that, in use, the flexible substrate can be wrapped at least partially around the spindle.

7. The thermoelectric device of any preceding claim, further comprising a plurality of thermoelectric elements disposed on the substrate, wherein the plurality of thermoelectric elements is electrically connected in series.

8. The thermoelectric device of any preceding claim, further comprising:

   at least one conductive member having a thermal conductivity of more than $10\,Wm^{-1}K^{-1}$ coupled to the first end of the spindle, or to the second end of the spindle; and/or at least one thermally conductive connector configured to connect at least a portion of the substrate proximate the hot side to at least one conductive portion coupled to the first end of the spindle; and/or at least one thermally conductive connector configured to connect at least a portion of the substrate proximate the cold side to at least one conductive portion coupled to the second end of the spindle.

9. The thermoelectric device of any preceding claim, wherein the spindle comprises nylon.

10. The thermoelectric device of any preceding claim, wherein, in use:

    at least one thermoelectric element disposed on the substrate lies, on average, further from the spindle than the substrate is; or at least one thermoelectric element disposed on the substrate lies, on average, closer to the spindle than the substrate is.

11. The thermoelectric device of any preceding claim, wherein the thermoelectric device is at least partially encapsulated in an outer enclosure.

12. A wireless sensor system, or a pipeline monitoring system, comprising one or more sensors and one or more thermoelectric devices according to any one of claims 1 to 11.

13. Use of the thermoelectric generator of any one of claims 1 to 11 to generate electricity, the use comprising: connecting the hot side of the thermoelectric generator to a high temperature source; and connecting the cold side of the thermoelectric generator to a low temperature source, thereby setting up a temperature difference across the thermoelectric element(s).

14. A method of manufacturing or assembling a thermoelectric device according to any of claims 1 to 11 comprising:

providing a spindle, the spindle having a first end and a second end, wherein the spindle further comprises, in series, a middle portion and at least one end portion at the first end and/or the second end of the spindle, the end portion(s) having a lower thermal resistance than the middle portion of the spindle;

arranging the spindle such that, in use, the first end is proximate the hot side and the second end is proximate the cold side of the thermoelectric device, and;

providing a substrate with at least one thermoelectric element disposed thereon; and

arranging the substrate between the first end and the second end of the spindle such that the or each thermoelectric element overlaps with the end portion(s) of the spindle;

wherein the effective thermal resistance of the spindle between the first end and the second end is more than 0.1 KW$^{-1}$.

15. The method of claim 14, further comprising manufacturing the spindle, optionally comprising: connecting two or more portions of the spindle together, such as a thermally conductive end portion and a less thermally conductive middle portion, and optionally wherein the portions may be mechanically connected or bonded together.

**Patentansprüche**

1. Thermoelektrische Vorrichtung, z. B. thermoelektrischer Generator, (101), die in Verwendung eine heiße Seite (113, 313) und eine kalte Seite (112, 312) aufweist, wobei die thermoelektrische Vorrichtung Folgendes umfasst: eine Spindel (111, 311) mit einem ersten Ende und einem zweiten Ende, wobei die Spindel so angeordnet ist, dass in Verwendung das erste Ende nahe der heißen Seite ist und das zweite Ende nahe der kalten Seite der thermoelektrischen Vorrichtung ist; und wenigstens ein thermoelektrisches Element (103, 104), das auf einem Substrat (101) zwischen dem ersten Ende und dem zweiten Ende der Spindel angeordnet ist, wobei die Spindel ferner in Reihe einen Mittelteil (301) und wenigstens einen Endteil (302, 303) an dem ersten Ende und/oder dem zweiten Ende der Spindel umfasst, wobei der/die Endteil(e) einen geringeren Wärmewiderstand als der Mittelteil der Spindel aufweist/aufweisen; wobei der effektive Wärmewiderstand der Spindel zwischen dem ersten Ende und dem zweiten Ende mehr als 0,1 KW$^{-1}$ beträgt; und wobei das oder jedes thermoelektrische Element mit dem/den Endteil(en) der Spindel überlappt (305, 306).

2. Thermoelektrische Vorrichtung nach Anspruch 1, wobei die effektive Wärmeleitfähigkeit der Spindel zwischen der heißen Seite und der kalten Seite weniger als 10 Wm$^{-1}$K$^{-1}$, weniger als 5 Wm$^{-1}$K$^{-1}$ oder weniger als 1 Wm$^{-1}$K$^{-1}$ beträgt.

3. Thermoelektrische Vorrichtung nach Anspruch 1 oder Anspruch 2, wobei die effektive Wärmeleitfähigkeit des/der Endteils/Endteile mehr als 10 Wm$^{-1}$K$^{-1}$ beträgt.

4. Thermoelektrische Vorrichtung nach Anspruch 1, Anspruch 2 oder Anspruch 3, wobei die Spindel ein unterschiedliches Material an einem oder an beiden Endteilen umfasst, so dass die Wärmeleitfähigkeit des/der Endteils/Endteile größer als die des Mittelteils ist.

5. Thermoelektrische Vorrichtung nach einem der Ansprüche 1 bis 4, wobei die Spindel einen Endteil an sowohl dem ersten Ende als auch dem zweiten Ende der Spindel und einen Mittelteil zwischen den Endteilen umfasst.

6. Thermoelektrische Vorrichtung nach einem der vorhergehenden Ansprüche, wobei das Substrat ein flexibles Substrat ist, derart, dass das flexible Substrat in Verwendung wenigstens teilweise um die Spindel gewickelt werden kann.

7. Thermoelektrische Vorrichtung nach einem der vorhergehenden Ansprüche, die ferner mehrere thermoelektrische Elemente umfasst, die auf dem Substrat angeordnet sind, wobei die mehreren thermoelektrischen Elemente elektrisch in Reihe verbunden sind.

8. Thermoelektrische Vorrichtung nach einem der vorhergehenden Ansprüche, die ferner Folgendes umfasst:

wenigstens ein leitfähiges Element mit einer Wärmeleitfähigkeit von mehr als 10 Wm$^{-1}$K$^{-1}$, das mit dem ersten Ende der Spindel oder mit dem zweiten Ende der Spindel gekoppelt ist; und/oder

wenigstens einen wärmeleitfähigen Verbinder, der dazu konfiguriert ist, wenigstens einen Teil des Substrats nahe der heißen Seite mit wenigstens einem leitfähigen Teil zu verbinden, der mit dem heißen Ende der Spindel gekoppelt ist; und/oder

wenigstens einen wärmeleitfähigen Verbinder, der dazu konfiguriert ist, wenigstens einen Teil des Substrats nahe der kalten Seite mit wenigstens einem leitfähigen Teil zu verbinden, der mit dem zweiten Ende der Spindel gekoppelt ist.

9. Thermoelektrische Vorrichtung nach einem der vorhergehenden Ansprüche, wobei die Spindel Nylon umfasst.

10. Thermoelektrische Vorrichtung nach einem der vorhergehenden Ansprüche, wobei in Verwendung:

   wenigstens ein thermoelektrisches Element, das auf dem Substrat angeordnet ist, im Durchschnitt weiter von der Spindel weg liegt als das Substrat; oder

   wenigstens ein thermoelektrisches Element, das auf dem Substrat angeordnet ist, im Durchschnitt näher an der Spindel liegt als das Substrat.

11. Thermoelektrische Vorrichtung nach einem der vorhergehenden Ansprüche, wobei die thermoelektrische Vorrichtung wenigstens teilweise in einer äußeren Umhüllung verkapselt ist.

12. Drahtlossensorsystem oder Pipeline-Überwachungssystem, das einen oder mehrere Sensoren und eine oder mehrere thermoelektrische Vorrichtungen nach einem der Ansprüche 1 bis 11 umfasst.

13. Verwendung des thermoelektrischen Generators nach einem der Ansprüche 1 bis 11 zum Erzeugen von Elektrizität, wobei die Verwendung Folgendes umfasst:

   Verbinden der heißen Seite des thermoelektrischen Generators mit einer Hochtemperaturquelle; und
   Verbinden der kalten Seite des thermoelektrischen Generators mit einer Niedrigtemperaturquelle, wodurch eine Temperaturdifferenz über das/die thermoelektrische(n) Element(e) eingerichtet wird.

14. Verfahren zum Herstellen oder Zusammenbauen einer thermoelektrischen Vorrichtung nach einem der Ansprüche 1 bis 11, das Folgendes umfasst:

   Bereitstellen einer Spindel, wobei die Spindel ein erstes Ende und ein zweites Ende umfasst, wobei die Spindel ferner in Reihe einen Mittelteil und wenigstens einen Endteil an dem ersten Ende und/oder dem zweiten Ende der Spindel umfasst, wobei der/die Endteil(e) einen geringeren Wärmewiderstand als der Mittelteil der Spindel aufweist/aufweisen;
Anordnen der Spindel derart, dass in Verwendung das erste Ende nahe der heißen Seite ist und das zweite Ende nahe der kalten Seite der thermoelektrischen Vorrichtung ist; und
Bereitstellen eines Substrats mit wenigstens einem darauf angeordneten thermoelektrischen Element; und
Anordnen des Substrats zwischen dem ersten Ende und dem zweiten Ende der Spindel, so dass das oder jedes thermoelektrische Element mit dem/den Endteil(en) der Spindel überlappt; wobei der effektive Wärmewiderstand der Spindel zwischen dem ersten Ende und dem zweiten Ende mehr als 0,1 $KW^{-1}$ beträgt.

15. Verfahren nach Anspruch 14, das ferner Herstellen der Spindel umfasst, was optional Folgendes umfasst:

   Verbinden von zwei oder mehr Teilen der Spindel miteinander, wie etwa einem wärmeleitfähigen Endteil und einem weniger wärmeleitfähigen Mittelteil, und
   wobei optional die Teile mechanisch miteinander verbunden oder gebondet werden können.

## Revendications

1. Dispositif thermoélectrique, par exemple un générateur thermoélectrique, (101) ayant, en utilisation, un côté chaud (113, 313) et un côté froid (112, 312), le dispositif thermoélectrique comprenant : une broche (111, 311) ayant une première extrémité et une seconde extrémité, la broche étant agencée de telle sorte, qu'en utilisation, la première extrémité est à proximité du côté chaud et la seconde extrémité est à proximité du côté froid du dispositif thermoélectrique ; et au moins un élément thermoélectrique (103, 104) disposé sur un substrat (101) entre la première extrémité et la seconde extrémité de la broche ; la broche comprenant en outre, en série, une partie intermédiaire (301) et au moins une partie d'extrémité (302, 303) au niveau de la première extrémité et/ou de la seconde extrémité de la broche, la ou les parties d'extrémité ayant une résistance thermique inférieure à celle de la partie intermédiaire de la broche ; la résistance thermique efficace de la broche entre la première extrémité et la seconde extrémité étant supérieure à 0,1 $KW^{-1}$ ; et le ou chaque élément thermoélectrique se chevauchant (305, 306) avec la ou les partie d'extrémité de la broche.

2. Dispositif thermoélectrique selon la revendication 1, la conductivité thermique efficace de la broche entre le côté chaud et le côté froid étant inférieure à 10 Wm$^{-1}$K$^{-1}$, inférieure à 5 Wm$^{-1}$K$^{-1}$ ou inférieure à 1 Wm$^{-1}$K$^{-1}$.

3. Dispositif thermoélectrique selon la revendication 1 ou la revendication 2, la conductivité thermique efficace de la ou des parties d'extrémité étant supérieure à 10 Wm$^{-1}$K$^{-1}$.

4. Dispositif thermoélectrique selon la revendication 1, la revendication 2 ou la revendication 3, la broche comprenant un matériau différent au niveau d'une ou des deux parties d'extrémité, de telle sorte que la conductivité thermique de la ou des parties d'extrémité est supérieure à celle de la partie intermédiaire.

5. Dispositif thermoélectrique selon l'une quelconque des revendications 1 à 4, la broche comprenant une partie d'extrémité à la fois au niveau de la première extrémité et au niveau de la seconde extrémité de la broche, et une partie intermédiaire entre les parties d'extrémité.

6. Dispositif thermoélectrique selon l'une quelconque des revendications précédentes, le substrat étant un substrat souple de telle sorte qu'en utilisation, le substrat souple peut être enroulé au moins partiellement autour de la broche.

7. Dispositif thermoélectrique selon l'une quelconque des revendications précédentes, comprenant en outre une pluralité d'éléments thermoélectriques disposés sur le substrat, la pluralité d'éléments thermoélectriques étant électriquement connectée en série.

8. Dispositif thermoélectrique selon l'une quelconque des revendications précédentes, comprenant en outre :

   au moins un élément conducteur présentant une conductivité thermique supérieure à 10 Wm$^{-1}$K$^{-1}$ couplé à la première extrémité de la broche ou à la seconde extrémité de la broche ; et/ou
   au moins un connecteur thermoconducteur configuré pour connecter au moins une partie du substrat à proximité du côté chaud à au moins une partie conductrice couplée à la première extrémité de la broche ; et/ou
   au moins un connecteur thermoconducteur configuré pour connecter au moins une partie du substrat à proximité du côté froid à au moins une partie conductrice couplée à la seconde extrémité de la broche.

9. Dispositif thermoélectrique selon l'une quelconque des revendications précédentes, la broche comprenant du nylon.

10. Dispositif thermoélectrique selon l'une quelconque des revendications précédentes, dans lequel, en utilisation :

    au moins un élément thermoélectrique disposé sur le substrat repose, en moyenne, plus loin de la broche que le substrat ; ou
    au moins un élément thermoélectrique disposé sur le substrat repose, en moyenne, plus près de la broche que le substrat.

11. Dispositif thermoélectrique selon l'une quelconque des revendications précédentes, le dispositif thermoélectrique étant au moins partiellement encapsulé dans une enceinte extérieure.

12. Système de capteurs sans fil, ou système de surveillance de pipeline, comprenant un ou plusieurs capteurs et un ou plusieurs dispositifs thermoélectriques selon l'une quelconque des revendications 1 à 11.

13. Utilisation du générateur thermoélectrique selon l'une quelconque des revendications 1 à 11 pour générer de l'électricité, l'utilisation comprenant : le raccordement du côté chaud du générateur thermoélectrique à une source de haute température ; et le raccordement du côté froid du générateur thermoélectrique à une source de basse température, ce qui permet d'établir une différence de température à travers le ou les éléments thermoélectriques.

14. Procédé de fabrication ou d'assemblage d'un dispositif thermoélectrique selon l'une quelconque des revendications 1 à 11 comprenant :

    la fourniture d'une broche, la broche ayant une première extrémité et une seconde extrémité, la broche comprenant en outre, en série, une partie intermédiaire et au moins une partie d'extrémité au niveau de la première extrémité et/ou de la seconde extrémité de la broche, la ou les parties d'extrémité ayant une résistance thermique inférieure à celle de la partie intermédiaire de la broche ;
    l'agencement de la broche de telle sorte, qu'en utilisation, la première extrémité est à proximité du côté chaud et la seconde extrémité est à proximité du côté froid du dispositif thermoélectrique, et ;
    la fourniture d'un substrat avec au moins un élément thermoélectrique disposé sur celui-ci ; et
    l'agencement du substrat entre la première extrémité et la seconde extrémité de la broche de telles sorte que le ou chaque élément thermoélectrique chevauche la ou les parties d'extrémité de la broche ;

la résistance thermique efficace de la broche entre la première extrémité et la seconde extrémité étant supérieure à 0,1 KW$^{-1}$.

**15.** Procédé selon la revendication 14, comprenant en outre la fabrication de la broche, comprenant éventuellement : le raccordement d'au moins deux parties de la broche ensemble, telles qu'une partie d'extrémité thermoconductrice et une partie intermédiaire moins thermoconductrice, et éventuellement, les parties pouvant être raccordées ou liées mécaniquement ensemble.

Figure 1A

Figure 1B

Figure 2

Figure 3

Figure 4

Figure 5

Figure 6

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CA 2549826 C
- US 3758346 A

- US 20080017238 A1

**Non-patent literature cited in the description**

- *Journal of Applied Physics: Conference series,* 2014, vol. 557, 012016